# EUROPÄISCHE PATENTSCHRIFT

(11) **EP 2 367 966 B1**
(45) Veröffentlichungstag und Bekanntmachung des Hinweises auf die Patenterteilung: **31.07.2013**
(21) Anmeldenummer: 09807487.5
(22) Anmeldetag: 04.12.2009
(51) Int. Cl.: C23C 18/16, C23C 18/20, C23C 18/30, C23C 18/08, C23C 18/12, H05K 3/18, H05K 3/38, H05K 3/24

(54) **SICHERHEITS- UND/ODER WERTDOKUMENT MIT EINER LEITFÄHIGEN STRUKTUR UND VERFAHREN ZU DESSEN HERSTELLUNG**
SECURITY AND/OR VALUABLE DOCUMENT COMPRISING A CONDUCTIVE STRUCTURE AND METHOD FOR PRODUCING SAME
DOCUMENT DE SÉCURITÉ ET/OU DE VALEUR COMPORTANT UNE STRUCTURE CONDUCTRICE ET PROCÉDÉ DE FABRICATION

(30) Priorität: 23.12.2008 DE 102008063030
(43) Veröffentlichungstag der Anmeldung: 28.09.2011
(73) Patentinhaber: Bundesdruckerei GmbH, 10985 Berlin (DE)
(72) Erfinder: MUTH, Oliver, 12277 Berlin (DE); HAGEMANN, Michael, 13465 Berlin (DE); PAESCHKE, Manfred, 16352 Basdorf (DE); FLEISCHER, Peter, 85570 Markt Schwaben (DE); WEFRINGHAUS, Eckhardt, 88709 Meersburg (DE)
(74) Vertreter: Jungblut, Bernhard Jakob
(86) Internationale Anmeldenummer: PCT/DE2009/001717
(87) Internationale Veröffentlichungsnummer: WO 2010/072192

(56) Entgegenhaltungen:
- WO-A1-2008/015167
- WO-A2-02/099163
- US-A- 5 648 414
- US-A1- 2005 241 949

## Beschreibung

### Gebiet der Erfindung

Die Erfindung betrifft ein Verfahren zur Herstellung einer für elektrischen Strom leitfähigen Schicht auf einem Substrat mit den folgenden Verfahrensschritten: auf das Substrat wird eine Beschichtung aus einer ersten Zubereitung aufgebracht, welche elektrisch leitende Partikel enthält, das Substrat mit der Beschichtung wird mit einer zweiten Zubereitung zur autokatalytischen stromlosen Metallbeschichtung behandelt. Die Erfindung betrifft des Weiteren eine so erhältliche Leitstruktur und ein Sicherheits- und/oder Wertdokument mit einer solchen Leitstruktur.

### Stand der Technik und Hintergrund der Erfindung.

Sicherheits- und/oder Wertdokumente, wie beispielsweise Personalausweise, Reisepässe, ID-Karten, Zugangskontrollausweise, Visa, Tickets, Führerscheine, Kraftfahrzeugpapiere, personalisierte Wertpapiere Kreditkarten, oder personalisierte Chipkarten, weisen zunehmend elektronische Schaltkreise, und sonstige aktive und passive elektronische Bauelemente, wie beispielsweise integrierte Halbleiter (ICs), aber auch Chipmodule, Displays, Batterien, Spulen, Kondensatoren, Kontaktstellen, usw., auf. In diesem Zusammenhängen ist es oft notwendig, auf oder innerhalb des Sicherheits- und/oder Wertdokumentes leitfähige Strukturen (Leitstrukturen), beispielsweise Leiterbahnen, einzurichten, welche elektronische Komponenten miteinander elektrisch verbinden oder auch eigenständige Funktionen innerhalb eines Schaltkreises ausüben. Letzteres ist beispielsweise im Falle einer RFID Antenne gegeben.

Die Herstellung von solchen Leitstrukturen kann auf verschiedene Weisen erfolgen. Bekannt ist es, Zubereitungen mit elektrisch leitfähigen Partikeln auf ein Substrat aufzubringen. Dabei kann die Auftragung beispielsweise mittels einschlägig bekannter Drucktechnologien erfolgen. Auf diese Weise hergestellte Leitstrukturen besitzen eine relativ geringe Leitfähigkeit, verglichen mit Strukturen aus metallischen Werkstoffen. Dies stört unter anderem in Hinblick auf störende Ohm'sche Verluste, geringere Induktivität, geringere Güte und hohe Ansprechfeldstärken. Ein Vorteil des Aufdruckens einer Leitstruktur insbesondere auf Substrate aus organischen Polymerwerkstoffen ist, dass ein guter Haftverbund zwischen Substrat und Leitstruktur entsteht auf grund der in Druckfarben eingesetzten Bindemittel auf Basis organischer Polymere.

Ferner ist es bekannt, Leitstrukturen auf nicht-leitenden Substraten dadurch herzustellen, dass direkt auf das Substrat oder nach vorheriger Aufbringung einer sogenannten Saat-Schicht (englisch Seed-Layer) ein Metall autokatalytisch und stromlos abgeschieden wird. Hierzu wird im Einzelnen beispielsweise auf die Literaturstelle WO 2006/065221 A1 verwiesen. Dabei ist der Seed-Layer typischerweise sehr dünn, meist 1 - 3 µm, und der darauf abgeschiedene Metallfilm ist um ein vielfaches dicker, meist 5 - 50 µm, als der Seed-Layer. Bei dieser Technologie ist der Haftverbund zwischen Seed-Layer und Substrat einerseits sowie zwischen abgeschiedener Metallschicht und Seed-Layer andererseits problematisch. Während dies im Falle von starren Substraten, wie beispielsweise Silizium Substraten nicht notwendigerweise problematisch ist, entstehen daraus jedoch erhebliche Probleme im Falle von flexiblen Substraten, wie beispielsweise Folien aus organischen Polymerwerkstoffen, wie sie im Bereich der Sicherheits- und/oder Wertdokumente eingesetzt werden.

Aus den Literaturstellen WO 2008/015167 A1, WO2002/099163 A2, US 2005/241949 A1 und US 5,648,414 A sind verschiedene Verfahren zur stromlosen Metallabscheidung bekannt.

### Technisches Problem der Erfindung

Der Erfindung liegt daher das technische Problem zu Grunde, ein Verfahren zur Herstellung einer für elektrischen Strom leitfähigen Schicht auf einem Substrat Sicherheits- und/oder Wertdokument anzugeben, wobei die leitfähige Schicht einen guten Haftverbund mit dem Substrat eingeht und gleichzeitig eine verbesserte Leitfähigkeit aufweist.

### Grundzüge der Erfindung und bevorzugte Ausführungsformen

Zur Lösung dieses technischen Problems lehrt die Erfindung den Gegenstand des Anspruchs 1.

Die Erfindung beruht auf der Erkenntnis, dass im Zuge der Trocknungsverfahrensstufe das Lösemittel aus der Beschichtung ausgetrieben wird, wobei die Beschichtung zwischen den Partikeln und in der Bindemittelmatrix ein Porensystem mit miteinander verbundenen offenen Poren ausbildet. Je nach Anteil Lösemittel in der ersten Zubereitung ist der Volumenanteil der Poren groß oder klein. Im Extremfall der maximalen Porosität sind die elektrisch leitenden Partikel mit einer dünnen Schicht des Bindemittels umgeben, wobei die Partikel in Berührungsbereichen miteinander und mit dem Substrat verbunden bzw. verklebt sind. Die Porosität entspricht dann im Kern jener einer losen Schüttung der Partikel. wesentlich für die Erfindung ist nun, dass in der Stufe c) eine Abscheidung nicht nur auf der äußeren Oberfläche der Beschichtung, sondern auch auf inneren Oberflächen, nämlich in den Porenräumen, stattfindet. Die Poren werden gleichsam verfüllt mit abgeschiedenem Metall und bilden ein Netzwerk aus Metall. Im Ergebnis wird eine leitfähige Struktur erhalten, die die Leitfähigkeit des eingesetzten Metalls aufweisz, jedoch auf Grund der Bindemittelmatrix eine sehr gute Haftung auf dem Substrat zeigt.

Die offene Porosität der Beschichtung nach der Stufe b) und vor der Stufe c), gemessen mit der Quecksilbermethode oder der Xylolmethode, liegt typischerweise im Bereich von 0,005 bis 0,45, meist von 0,02 bis 0,10.

Während als Substrat grundsätzlich jedes beliebige Material in Frage kommt, ist im Rahmen von Sicherheits- und/cder Wertdokumenten bevorzugt, wenn es sich um ein organisches Polymer, vorzugsweise ausgewählt aus der Gruppe bestehend aus "PC (Polycarbcnat, insbesondere Bisphenol A Polycarbonat), PET (Polyethylenglykolterephthalat), PET-G, PET-F, PMMA (Polymethylmethacrylat), ABS (Acrylnitril-Butadien-Styrol), PE (Polyethylen), PP (Polypropylen), PI (Polyimid oder Poly-trans-Isopren), PVC (Polyvinylchlorid) und Copolymere solcher Polymere", handelt. Insbesondere PC ist bevorzugt auf Grund seiner in diesem technologischen Bereich bekannten vorteilhaften sonstigen Eigenschaften.

Dann kann das Substrat beispielsweise eine Folie oder ein Folienverbund eines Sicherheits- und/oder Wertdokumentes, insbesondere eines Personalausweises, Reisepasses, einer ID-Karte, eines Zugangskontrollausweises, Visums, Tickets, Führerscheines, Kraftfahrzeugpapiers, personalisierten wertpapiers, einer Kreditkarte, oder personalisierte Chipkarten, sein.

Grundsätzlich kann mit leitfähigen Schichten eine beliebige elektrische Funktion realisiert werden. So können beispielsweise Leiterbahnen zur "drahtgebundenen" Übertragung von elektrischen Signalen und/oder elektrischer Energie ausgebildet und gestaltet sein. Es kann sich bei einer leitfähigen Schicht aber auch um eine Spulenstruktur, genauer gesagt Antennenstruktur handeln, insbesondere eine Antennenstruktur, die Teil eines RFID Schaltkreises ist.

Das in der ersten Zubereitung enthaltene Bindemittel kann grundsätzlich jedes beliebige in der Beschichtungstechnologie, einschließlich der Lacktechnologie und Drucktechnologie, üblicherweise eingesetzte Bindemittel oder Bindemittelmischung sein, wobei der Fachmann ohne weiteres ein für ein bestimmtes Substratmaterial geeignetes und hiermit kompatibles Bindemittel auswählen wird. Auch wird die geeignete und durch den Fachmann ohne weiteres ausführbare Wahl der Zusammensetzung der ersten Zubereitung von der Art der Aufbringung abhängen, beispielsweise von der eingesetzten Drucktechnologie.

Typische Schichtdicken einer Beschichtung der Stufe a) liegen im Bereich von 0,5 - 100 µm, insbesondere 5 - 50 µm, meist 10 - 30 µm.

Ein gut geeignetes Bindemittel ist beispielsweise ein Polycarbonatderivat auf Basis eines geminal disubstituierten Dihydroxydiphenylcycloalkans, welches ein mittleres Molekulargewicht (Gewichtsmittel) von mindestens 10.000, vorzugsweise von 20.000 bis 300.000, aufweisen kann. Im Einzelnen kann das Polycarbonatderivat funktionelle Carbonatstruktureinheiten der Formel (I) enthalten, 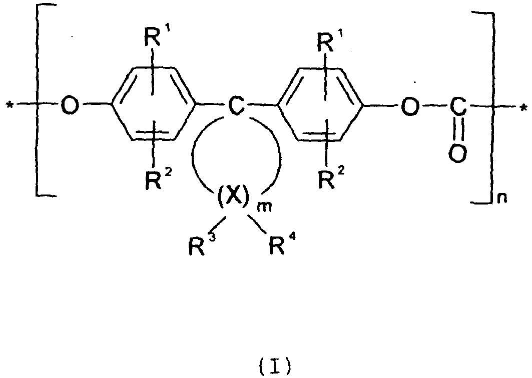 worin R¹ und R² unabhängig voneinander Wasserstoff, Halogen, bevorzugt Chlor oder Brom, C₁-C₈-Alkyl, C₅-C₆-Cycloalkyl, C₆-C₁₀-Aryl, bevorzugt Phenyl, und C₇-C₁₂-Aralkyl, bevorzugt Phenyl-C₁-C₄-Alkyl, insbesondere Benzyl; m eine ganze Zahl von 4 bis 7, bevorzugt 4 oder 5; R³ und R⁴ für jedes X individuell wählbar, unabhängig voneinander Wasserstoff oder C₁-C₆-Alkyl; X Kohlenstoff und n eine ganze Zahl größer 20 bedeuten, mit der Maßgabe, dass an mindestens einem Atom X, R³ und R⁴ gleichzeitig Alkyl bedeuten. Weiterhin bevorzugt ist es, wenn an 1 bis 2 Atomen X, insbesondere nur an einem Atom X, R³ und R⁴ gleichzeitig Alkyl sind. R³ und R⁴ können insbesondere Methyl sein. Die X-Atome in alpha-Stellung zu dem Diphenyl-substituierten C-Atom (C1) können nicht dialkylsubstituiert sein. Die X-Atome in beta-Stellung zu C1 können mit Alkyl disubstituiert sein. Bevorzugt ist m = 4 oder 5. Das Polycarbonatderivat kann beispielsweise auf Basis von Monmeren, wie 4,4'-(3,3,5-trimethylcyclohexan-1,1-diyl)diphenol, 4,4'-(3,3-dimethylcyclohexan-1,1-diyl)diphenol, oder 4,4'-(2,4,4-trimethylcyclopentan-1,2-diyl)diphenol gebildet sein. Ein solches Polycarbonatderivat kann beispielsweise gemäß der Literaturstelle DE 38 32 396.6 aus Diphenolen der Formel (Ia) hergestellt werden, deren Offenbarungsgehalt hiermit vollumfänglich in den Offenbarungsgehalt dieser Beschreibung aufgenommen wird. Es können sowohl ein Diphenol der Formel (Ia) unter Bildung von Homopolycarbonaten als auch mehrere Diphenole der Formel (Ia) unter Bildung von Copolycarbonaten verwendet werden (Bedeutung von Resten, Gruppen und Parametern, wie in Formel I).

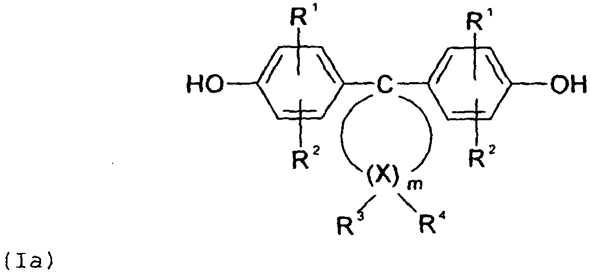

Ausserdem können die Diphenole der Formel (Ia) auch im Gemisch mit anderen Diphenolen, beispielsweise mit denen der Formel (Ib) HO - Z - OH (Ib), zur Herstellung von hochmolekularen, thermoplastischen, aromatischen Polycarbonatderivaten verwendet werden. Geeignete andere Diphenole der Formel (Ib) sind solche, in denen Z ein aromatischer Rest mit 6 bis 30 C-Atomen ist, der einen oder mehrere aromatische Kerne enthalten kann, substituiert sein kann und aliphatische Reste oder andere cycloaliphatische Reste als die der Formel (Ia) oder Heteroatome als Brückenglieder enthalten kann. Beispiele der Diphenole der Formel (Ib) sind: Hydrochinon, Resorcin, Dihydroxydiphenyle, Bi-(hydroxyphenyl)-alkane, Bis-(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha , alpha '-Bis-(hydroxyphenyl)-diisopropylbenzole sowie deren kernalkylierte und kernhalogenierte Verbindungen. Diese und weitere geeignete Diphenole sind z.B. in den Literaturstellen US-A 3 028 365, 2 999 835, 3 148 172, 3 275 601, 2 991 273, 3 271 367, 3 062 781, 2 970 131 und 2 999 846, in den Literaturstellen DE-A 1 570 703, 2 063 050, 2 063 052, 2 211 956, der Fr-A 1 561 518 und in der Monographie "H. Schnell, Chemistry and Physics of Polycarbonates, Interscience Publishers, New York 1964", beschrieben, welche hiermit vollumfänglich in den Offenbarungsgehalt der vorliegenden Anmeldung aufgenommen werden. Bevorzugte andere Diphenole sind beispielsweise: 4,4'-Dihydroxydiphenyl, 2,2-Bis-(4-hydroxyphenyl)-propan, 2,4-Bis-(4-hydroxyphenyl)-2-methylbutan, 1,1-Bis-(4-hydroxyphenyl)-cyclohexan, alpha , alpha -Bis-(4-hydroxyphenyl)-p-diisopropylbenzol, 2,2-Bis-(3-methyl-4-hydroxyphenyl)-propan, 2,2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,1-Bis-(3,5-dimethyl-4-hydroxyphenyl)-cyclohexan, alpha , alpha -Bis-(3,5-dimethyl-4-hydroxyphenyl)-p-diisopropylbenzol, 2,2-Bis-(3,5-dichlor-4-hydrdxyphenyl)-propan und 2,2-Bis-(3,5-dibrom-4-hydroxyphenyl)-propan. Besonders bevorzugte Diphenole der Formel (Ib) sind beispielsweise: 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan und 1,1-Bis-(4-hydroxyphenyl)-cyclohexan. Insbesondere ist 2,2-Bis-(4-hydroxyphenyl)-propan bevorzugt. Die anderen Diphenole können sowohl einzeln als auch im Gemisch eingesetzt werden. Das molare Verhältnis von Diphenolen der Formel (Ia) zu den gegebenenfalls mitzuverwendenden anderen Diphenolen der Formel (Ib), soll zwischen 100 Mol-% (Ia) zu 0 Mol-% (Ib) und 2 Mol-% (Ia) zu 98 Mol-% (Ib), vorzugsweise zwischen 100 Mol-% (Ia) zu 0 Mol-% (Ib) und 10 Mol-% (Ia) zu 90 Mol-% (Ib) und insbesondere zwischen 100 Mol-% (Ia) zu 0 Mol-% (Ib) und 30 Mol-% (Ia) zu 70 Mol-% (Ib) liegen. Die hochmolekularen Polycarbonatderivate aus den Diphenolen der Formel (Ia), gegebenenfalls in Kombination mit anderen Diphenolen, können nach den bekannten Polycarbonat-Herstellungsverfahren hergestellt werden. Dabei können die verschiedenen Diphenole sowohl statistisch als auch blockweise miteinander verknüpft sein. Die demgemäß eingesetzten Polycarbonatderivate können in an sich bekannter Weise verzweigt sein. Wenn die Verzweigung gewünscht wird, kann sich in bekannter Weise durch Einkondensieren geringer Mengen, vorzugsweise Mengen zwischen 0,05 und 2,0 Mol-% (bezogen auf eingesetzte Diphenole), an drei- oder mehr als dreifunktionellen Verbindungen, insbesondere solchen mit drei oder mehr als drei phenolischen Hydroxylgruppen, erreicht werden. Einige Verzweiger mit drei oder mehr als drei phenolischen Hydroxylgruppen sind: Phloroglucin, 4,6-Dimethyl-2,4,6-tri-(4-hydroxyphenyl)-hepten-2, 4,6-Dimethyl-2,4,6-tri-(4-hydroxyphenyl)-heptan, 1,3,5-Tri-(4-hydroxyphenyl)-benzol, 1,1,1-Tri-(4-hydroxyphenyl)-ethan, Tri-(4-hydroxyphenyl)-phenylmethan, 2,2-Bis-[4,4-bis-(4-hydroxyphenyl)-cyclohexyl]-propan, 2,4-Bis-(4-hydroxyphenyl-isopropyl)-phenol, 2,6-is-(2-hydroxy-5-methyl-benzyl)-4-methylphenol, 2-(4-hydroxyphenyl)-2-(2,4-dzhydroxyphenyl)-propan, Hexa-[4-(4-hydroxyphenyl-isopropyl)-phenyl]-orthoterephthalsäureester, Tetra-(4-hydroxyphenyl)-methan, Tetra-[4-(4-hydroxyphenyl-isopropyl)phenoxy]-methan und 1,4-Bis-[4',4"-dihydroxytriphenyl)-methyl]-benzol. Einige der sonstigen dreifunktionellen Verbindungen sind 2,4-Dihydroxybenzoesäure, Trimesinsäure, Cyanurchlorid und 3,3-Bis-(3-methyl-4-hydroxyphenyl)-2-oxo-2,3-dihydroindol. Als Kettenabbrecher zur an sich bekannten Regelung des Molekulargewichts der Polycarbonatderivate dienen monofunktionelle Verbindungen in üblichen Konzentraten. Geeignete Verbindungen sind z.B. Phenol, tert.-Butylphenole oder andere Alkyl-substituierte Phenole. Zur Regelung des Molekulargewichts sind insbesondere kleine Mengen Phenole der Formel (Ic) geeignet 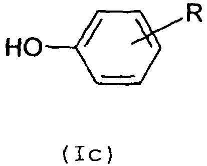 worin
R einen verzweigten C₈- und/oder C₉-Alkylrest darstellt. Bevorzugt ist im Alkylrest R der Anteil an CH₃-Protonen zwischen 47 und 89 % und der Anteil der CH- und CH₂-Protonen zwischen 53 und 11 %; ebenfalls bevorzugt ist R in o- und/oder p-Stellung zur OH-Gruppe, und besonders bevorzugt die obere Grenze des ortho-Anteils 20 %. Die Kettenabbrecher werden im allgemeinen in Mengen von 0,5 bis 10, bevorzugt 1,5 bis 8 Mol-%, bezogen auf eingesetzte Diphenole, eingesetzt. Die Polycarbonatderivate können vorzugsweise nach dem Phasengrenzflächenve rhalten (vgl. H. Schnell "Chemistry and Physics of Polycarbonates", Polymer Reviews, Vol. IX, Seite 33ff., Interscience Publ. 1964) in an sich bekannter Weise hergestellt werden. Hierbei werden die Diphenole der Formel (Ia) in wässrig alkalischer Phase gelöst. Zur Herstellung von Copolycarbonaten mit anderen Diphenolen werden Gemische von Diphenolen der Formel (Ia) und den anderen Diphenolen, beispielsweise denen der Formel (Ib), eingesetzt. Zur Regulierung des Molekulargewichts können Kettenabbrecher z.B. der Formel (Ic) zugegeben werden. Dann wird in Gegenwart einer inerten, vorzugsweise Polycarbonat lösenden, organischen Phase mit Phosgen nach der Methode der Phasengrenzflächenkondensation umgesetzt. Die Reaktionstemperatur liegt zwischen 0°C und 40°C. Die gegebenenfalls mitverwendeten Verzweiger (bevorzugt 0,05 bis 2,0 Mol-%) können entweder mit den Diphenolen in der wässrig alkalischen Phase vorgelegt werden oder in dem organischen Lösungsmittel gelöst vor Phosgenierung zugegeben werden. Neben den Diphenolen der Formel (Ia) und gegebenenfalls anderen Diphenolen (Ib) können auch deren Mono- und/oder Bis-chlorkohlensäureester mitverwendet werden, wobei diese in organischen Lösungsmitteln gelöst zugegeben werden. Die Menge an Kettenabbrechern sowie an Verzweigern richtet sich dann nach der molaren Menge von Diphenolat-Resten entsprechend Formel (Ia) und gegebenenfalls Formel (Ib); bei Mitverwendung von Chlorkohlensäureestern kann die Phosgenmenge in bekannter Weise entsprechend reduziert werden. Geeignete organische Lösungsmittel für die Kettenabbrecher sowie gegebenenfalls für die Verzweiger und die Chlorkohlensäureester sind beispielsweise Methylenchlorid, Chlorbenzol, insbesondere Mischungen aus Methylenchlorid und Chlorbenzol. Gegebenenfalls können die verwendeten Kettenabbrecher und Verzweiger im gleichen Solvens gelöst werden. Als organische Phase für die Phasengrenzflächenpolykondensation dient beispielsweise Methylenchlorid, Chlorbenzol sowie Mischungen aus Methylenchlorid und Chlorbenzol. Als wässrige alkalische Phase dient beispielsweise NaOH-Lösung. Die Herstellung der Polycarbonatderivate nach dem Phasengrenzflächenverfahren kann in üblicher Weise durch Katalysatoren wie tertiäre Amine, insbesondere tertiäre aliphatische Amine wie Tributylamin oder Triethylamin katalysiert werden; die Katalysatoren können in Mengen von 0,05 bis 10 Mol-%, bezogen auf Mole an eingesetzten Diphenolen, eingesetzt werden. Die Katalysatoren können vor Beginn der Phosgenierung oder während oder auch nach der Phosgenierung zugesetzt werden. Die Polycarbonatderivate können nach dem bekannten Verfahren in homogener Phase, dem sogenannten "Pyridinverfahren" sowie nach dem bekannten Schmelzeumesterungsverfahren unter Verwendung von beispielsweise Diphenylcarbonat anstelle von Phosgen hergestellt werden. Die Polycarbonatderivate können linear oder verzweigt sein, sie sind Homopolycarbonate oder Copolycarbonate auf Basis der Diphenole der Formel (Ia). Durch die beliebige Komposition mit anderen Diphenolen, insbesondere mit denen der Formel (Ib) lassen sich die Polycarbonateigenschaften in günstiger Weise variieren. In solchen Copolycarbonaten sind die Diphenole der Formel (Ia) in Mengen von 100 Mol-% bis 2 Mol-%, vorzugsweise in Mengen von 100 Mol-% bis 10 Mol-% und insbesondere in Mengen von 100 Mol-% bis 30 Mol-%, bezogen auf die Gesamtmenge von 100 Mol-% an Diphenoleinheiten, in Polycarbonatderivaten enthalten. Das Polycarbonatderivat ist beispielsweise ein Copolymer enthaltend, insbesondere bestehend aus, Monomereinheiten M1 auf Basis der Formel (Ib), insbesondere Bisphenol A, sowie Monomereinheiten M2 auf Basis des geminal disubstituierten Dihydroxydiphenylcycloalkans, vorzugsweise des 4,4'-(3,3,5-trimethylcyclohexan-1,1-diyl)diphenols, ist, wobei das Molverhältnis M2/M1 vorzugsweise größer als 0,3, insbesondere größer als 0,4, beispielsweise größer als 0,5 ist.

Als Lösemittel der ersten Zubereitung kommen neben Wasser alle in der Beschichtungstechnologie üblichen organischen Lösemittel und Lösemittelmischungen, auch mit Wasser, in Frage. Lediglich beispielhaft seien vorzugsweise halogenfreie organische Lösungsmittel genannt. In Frage kommen u.a. aliphatische, cycloaliphatische, aromatische Kohlenwasserstoffe, wie Mesitylen, 1,2,4- Trimethylbenzol, Cumol und Solvent Naptha, Toluol, Xylol; (organische) Ester, wie Methylacetat, Ethylacetat, Butylacetat, Methoxypropylacetat, Ethyl-3-ethoxypropionat, Butyglykolacetat. Bevorzugt sind Mesitylen, 1,2,4-Trimethylbenzol, Cumol und Solvent Naptha, Toluol, Xylol, Essigsäuremethylester, Essigsäureethylester, Methoxypropylacetat, Ethyl-3-ethoxypropionat, ein oder mehrwertige C1-C10 Alkyl-, Cycloalkyl-, Aryl- (C6-C10), oder Aralkylalkohole (C6-C10), linear oder verzweigt. Ganz besonders bevorzugt sind: Mesitylen (1,3,5-Trimethylbenzol), 1,2,4-Trimethylbenzol, Cumol (2-Phenylpropan), Solvent Naptha und Ethyl-3-ethoxypropionat. Ein für das vorstehende im Detail erläuterte Bindemittel geeignetes Lösungsmittelgemisch umfasst beispielsweise A) 0 bis 10 Gew.-%, vorzugsweise 1 bis 5 Gew.-%, insbesondere 2 bis 3 Gew.-%, Mesitylen, B) 10 bis 50 Gew.-%, vorzugsweise 25 bis 50 Gew.-%, insbesondere 30 bis 40 Gew.-%, 1-Methoxy-2-propanolacetat, C) 0 bis 20 Gew.-%, vorzugsweise 1 bis 20 Gew.-%, insbesondere 7 bis 15 Gew.-%, 1,2,4-Trimethylbenzol, D) 10 bis 50 Gew.-%, vorzugsweise 25 bis 50 Gew.-%, insbesondere 30 bis 40 Gew.-%, Ethyl-3-ethoxypropionat, E) 0 bis 10 Gew.-%, vorzugsweise 0,01 bis 2 Gew.-%, insbesondere 0,05 bis 0,5 Gew.-%, Cumol, und 0 bis 80 Gew.-%, vorzugsweise 1 bis 40 Gew.-%, insbesondere 15 bis 25 Gew.-%, Solvent Naphtha, wobei die Summe der Komponenten A) bis E) stets 100 Gew.-% ergibt.

Die erste Zubereitung enthält vorzugsweise einen Anteil an Lösemittel, vorzugsweise organischem Lösemittel, von 2 - 30 Gew.%, insbesondere 4 bis 10 Gew.-%, bezogen auf das Gesamtgewicht der Zubereitung.

Die Partikel der ersten Zubereitung können grundsätzlich ebenfalls beliebige Komposition aufweisen. Es kann sich um anorganische nicht-metallische oder metallische Partikel, beispielsweise aus Metalloxiden, wie SiO2 oder TiO2, Ruß, Silber, Gold, Titan, Zinn, Palladium, Kupfer, oder sonstige in der Beschichtungstechnologie bekannte anorganische Füllstoffe, handeln. Es können aber auch Polymerpartikel eingesetzt werden, wie sie in der Beschichtungstechnologie beispielsweise als organische Füllstoffe bekannt sind.

Die erste Zubereitung weist vorzugsweise einen Anteil von 30 - 99 Gew.-%, insbesondere 70 bis 95 Gew.-%, an Partikeln, vorzugsweise elektrisch leitfähigen Partikeln, insbesondere Metallpartikeln, beispielsweise Silberpartikeln, auf.

Im Rahmen der Erfindung ist es bevorzugt, wenn die Partikelgröße bei zumindest 90%, bezogen auf das Volumen, der eingesetzten Partikel im Bereich zwischen 0,1 und 30 µm, insbesondere zwischen 2 und 20 µm, liegt. Die Partikelgrößenverteilung kann monomodal sein, es können aber auch Mischungen von Partikeln verschiedener Partikelgrößen bzw. Partikelgrößenverteilungen eingerichtet sein. Beispielsweise können in Verbindung miteinander d10-Werte von 0,5 bis 5 µm und d90-Werte von 5 bis 30 µm eingerichtet sein. Partikelgrößen und Partikelgrößenverteilungen, einschließlich d10- und d90-Werte lassen sich über statische Laserbeugungsmethoden, beispielsweise mit einem LS Particle Size Analyser (Beckmann Coulter) nach Standard Verfahren und Standard Auswertungssaftware messen.

Geeignete fertige erste Zubereitungen sind beispielsweise einschlägig bekannte Zubereitungen wie Conductor Paste DuPont 5029 oder 5028 oder 5033.

Die Aufbringung der ersten Zubereitung kann mit allen einschlägig bekannten Druckverfahren (z.B. Durch-, Tief-, Hoch- und Flachdruck aber auch Tintenstrahldruck, insbesondere Siebdruck) erfolgen. Aber auch andere in der Beschichtungstechnologie üblichen Aufbringungsverfahren, wie Spritzen, Streichen, Rakeln, Tauchen, etc. sind einsetzbar. Bevorzugt sind Siebdruck und Schablonendruck.

Die Stufe b) kann für 1 bis 30 min., durchgeführt werden. Es ist möglich im Rahmen der Stufe b) auch an Stelle der Erwärmung oder zusätzlich hierzu einen Unterdruck, beispielsweise im Bereich von 10 bis 800 mBar (absolut), insbesondere 100 bis 600 mBar, einzurichten.

Die zweite Zubereitung kann eine wässrige Lösung mit einem Metallsalz und einem Reduktionsmittel, sowie optional zusätzlich mit einem Komplexbildner und/oder einem oder mehreren Hilfsstoffen sein. Das Metallsalz kann ein Salz des Ag, Cu, Pd oder Co sein. Der Begriff des Salzes umfasst dabei auch Komplexe der Metalle bzw. Metallionen. Die Konzentration des Metallsalzes kann im Bereich von 0,05 - 50 g/l, vorzugsweise 0,3 - 10 g/l, insbesondere 0,4 - 2,0 g/l, bezogen auf das Metall, liegen. Als Gegenionenlieferant bzw. Komplexbildner kommen in Frage EDTA, Rochelle's Salz, Zitronensäure, Citrate, Weinsäure, Propionsäure, Acetate, Milchsäure, Pyrophosphate, Pyridium-3-Sulfonsäure, Tartrate, Phosphate, Borate, cyanide, Thiocyanide, Halogenide, Triethylentetramin, und Methylamin. Bei den vorstehenden Salzen können die eingesetzten Gegenionen beispielsweise Na⁺ oder K⁺ sein. Als Reduktionsmittel kommen in Frage Dextrose, Glyoxal, Rochelle's Salze, kristallisierter Zucker, invertierter Zucker, Co-Ionen, Hydride, Glucamine, Metallhydride, Hydrazine, Hydrazinsulfate, Borane, wie Dimethylaminboran, Diethylaminboran, Triethylaminboran, Formaldehyd, Hypophosphite, Gluconate, mehrwertige Alkohole, usw. Als Hilfsmittel kommen oberflächenaktive Substanzen, insbesondere nicht-ionisch, beispielsweise mit Ethylenglycol-Monomereinheiten bzw. Nonylphenolethoxylat in Frage, ebenso wie kommerziell erhältliche Mittel, wie Ethylan 1008W, HB1, D253, CO35, CPG660, 1005, CD127P/N, A4, BCD42 oder alle unter der Bezeichnung Berol vertriebene Mittel (alle von Akzo Nobel). Das oberflächenaktive Mittel kann in Konzentrationen von 0,01 - 10 g/l, insbesondere 0,1 - 1,0 g/l, bezogen auf die gesamte Zubereitung, vorliegen. Als Hilfsmittel kommen auch Polymere, wie Polyethylenglycol mit einem mittleren Molekulargewicht von 100 - 4000 da in Frage. Dies können in Konzentrationen von 0,01 - 10 g/l, insbesondere 0,1 - 1,0 g/l, bezogen auf die Zubereitung, vorliegen. Weiterhin können anorganische oder organische Säuren, wie Borsäure, im Mengen von 0,1 - 300g/l, bezogen auf die Zubereitung, vorgesehen sein. Ebenso können organische oder anorganische Basen, wie Kalium- Natrium-, Lithium-, Calcium-, oder Magnesiumhydroxid vorgesehen sein. Diese sind dann in einer Menge zugegen, die den pH vorzugsweise auf 5,0 - 8,5, vorzugsweise 6,0 - 7,5, insbesondere 6,0 - 7,2, speziell 6,8 - 7,2, einstellt. Im Rahmen der Erfindung ist es auch möglich, den pH Wert mittels geeigneter fachüblicher Puffer zu stabilisieren. Konkrete geeignete zweite Zusammensetzungen sind ansonsten in der Literaturstelle WO 2006/065221 A1 beschrieben.

Die Stufe c) wird vorzugsweise wenige °C, beispielsweise 2 - 5 °C, unterhalb der Trübungstemperatur der zweiten Zubereitung durchgeführt. Bevorzugte Badtemperaturen liegen über 20 °C, besser über 30 °C, insbesondere über 50 °C. Die Badtemperatur sollte zweckmäßigerweise unter 100 °C, besser unter 80 °C liegen.

Die Erfindung betrifft des Weiteren eine Leitstruktur nach Anspruch 11.

Eine solche Leitstruktur ist erhältlich mit dem erfindungsgemäßen Verfahren.

Die Erfindung umfasst auch ein Sicherheits- und/oder Wertdokument enthaltend eine solche Leitstruktur, insbesondere ausgebildet als RFID Antenne.

Alle Erläuterungen im Rahmen des erfindungsgemäßen Verfahrens gelten analog auch für die erfindungsgemäße Leitstruktur bzw. das erfindungsgemäße Sicherheits- und/oder Wertdokument.

Im Folgenden wird die Erfindung anhand eines lediglich eine Ausführungsform darstellenden Beispiels näher erläutert.

### Beispiel 1: Vergleichsbeispiel

Mit einem Siebdruckautomaten wurden Antennenstrukturen (HF-RFID-Antennen) auf Polycarbonatfolien einer Dicke von 100 µm gedruckt. Als Siebdruckpaste wurde das Produkt 5029 der Firma DuPont eingesetzt. Dieses Produkt enthält, metallische Silberpartikel, ein organisches Bindemittel und ein organisches Lösemittel. Es erfolgte eine Trocknung für 10 min. bei 100 °C.

Die so hergestellten Antennen hatten einen Gleichstromwiderstand von 30 - 35 Ohm bei einer Schichtdicke von 20 µm.

### Beispiel 2: erfindungsgemäßes Beispiel

Zunächst wurde eine Antennenstruktur gemäß dem Beispiel 1 mit gleichen Materialien und Dimensionen hergestellt.

Diese Antennenstruktur wurde dann mit einer Zubereitung gemäß der Literaturstelle WO 2006/065221 bei 70 °C jedoch einem pH von 7,0 für 10 min. behandelt. Dabei veränderte sich die Schichtdicke nur unwesentlich, eine Untersuchung des Querschnitts ergab, dass im Wesentlichen auch innerhalb der Antennenstruktur eine Abscheidung von Silber stattgefunden hatte.

Eine Messung des Widerstandes ergab eine Reduktion auf 8 - 11 Ohm.

Zur weiteren elektrische Charakterisierung wurde auf die Antenne ein RFID Chipmodul montiert und die Ansprechfeldstärke in Abhängigkeit der Übertragungsrate gemessen. Bei einer Übertragungsrate von 424 kbit/s wurden 1,5 A/m gemessen. Dieser Wert entspricht einem mit einer drahtgewickelten Antenne mit dem gleichen Modul erzielbaren Wert.

Die Haftung der Antennenstruktur auf der PC Folie entsprach jener des Beispiels 1.

## Patentansprüche

1. Verfahren zur Herstellung einer für elektrischen Strom leitfähigen Schicht auf einem Substrat mit den folgenden Verfahrensschritten:
a) auf das Substrat wird eine Beschichtung aus einer ersten Zubereitung aufgebracht, welche ein organisches Bindemittel, ein wässriges oder organisches Lösemittel und Partikel enthält,
b) das Substrat mit der Beschichtung wird einer Trocknungsverfahrensstufe für 0,1 bits 100 min. bei 60 bis 130 °C unterzogen, wobei das Lösemittel entfernt wird und wobei die Beschichtung zwischen den Partikeln und in der Bindemittelmatrix ein Porensystem mit miteinander verbundenen offenen Poren ausbildet, und
c) das Substrat mit der getrockneten Beschichtung wird mit einer zweiten Zubereitung zur autokatalytischen stromlosen Metallbeschichtung behandelt.

2. Verfahren nach Anspruch 1, wobei das Substrat eine organisches Polymer, vorzugsweise ausgewählt aus der Gruppe bestehend aus "PC (Polycarbonat, insbesondere Bisphenol A Polycarbonat), PET (Polyethylenglykolterephthalat), PET-G, PET-F, PMMA (Polymethylmethacrylat), ABS (Acrylnitril-Butadien-Styrol), PE (Polyethylen), PP (Polypropylen), PI (Polyimid oder Poly-trans-Isopren), PVC (Polyvinylchlorid) und Copolymere solcher Polymere", ist.

3. Verfahren nach einem der Ansprüche 1 oder 2, wobei das Substrat eine Folie oder ein Folienverbund eines Sicherheits- und/oder Wertdokumentes, insbesondere eines Personalausweises, Reisepasses, einer ID-Karte, eines Zugangskontrollausweises, Visums, Tickets, Führerscheines, Kraftfahrzeugpapiers, personalisierten Wertpapiers, einer Kreditkarte, oder personalisierte Chipkarten, ist.

4. Verfahren nach einem der Ansprüche 1 bis 3, wobei die leitfähige Schicht eine Antennenstruktur, insbesondere eines RFID Schaltkreises, ist.

5. Verfahren nach einem der Ansprüche 1 bis 4, wobei die Beschichtung mittels einer Druckverfahrenstechnik, insbesondere mittels Siebdruck, in Stufe a) aufgebracht wird.

6. Verfahren nach einem der Ansprüche 1 bis 5, wobei die erste Zubereitung einen Anteil an Lösemittel, vorzugsweise organischem Lösemittel, von 2 - 30 Gew.-%, insbesondere 4 bis 10 Gew.-%, bezogen auf das Gesamtgewicht der Zubereitung, enthält.

7. Verfahren nach einem der Ansprüche 1 bis 6, wobei die erste Zubereitung einen Anteil von 30 - 99 Gew.-%, vorzugsweise 70 bis 95 Gew.-%, an Partikel, vorzugsweise elektrisch leitfähigen Partikeln, insbesondere Metallpartikeln, beispielsweise Silberpartikeln, enthält.

8. Verfahren nach einem der Ansprüche 1 bis 7, wobei 90 % der Partikel, bezogen auf das Volumen, eine Partikelgröße im Bereich von 0,1 - 30 pm aufweisen.

9. Verfahren nach einem der Ansprüche 1 bis 8, wobei die zweite Zubereitung eine wässrige Lösung mit einem Metallsalz und einem Reduktionsmittel, sowie optional zusätzlich mit einem Komplexbildner und/oder einem oder mehreren Hilfsstoffen ist.

10. Verfahren nach einem der Ansprüche 1 bis 9, wobei der pH-Wert der zweiten Zubereitung mittels Hilfsstoffen auf 6,0 - 8,5, insbesondere 6,0 - 7,3, vorzugsweise 6,8 - 7,2, eingestellt ist, optional mittels eines Puffers.

11. Leitstruktur mit einem den elektrischen Strom nichtleitenden Substrat und einer auf dem Substrat angeordneten und hiermit verbundenen für elektrischen Strom leitfähigen Leitschicht, wobei die Leitschicht ein das Volumen der Leitschicht durchgreifendes metallisches Netzwerk aufweist, das in Zwischenräumen zwischen in der Leitschicht enthaltenen elektrisch leitenden oder nicht-leitenden Partikeln verlaufend angeordnet ist, wobei die Partikel miteinander und mit dem Substrat über ein organisches Bindemittel verbunden sind, erhältlich nach einem der Ansprüche 1 bis 10, wobei die offene Porosität der Beschichtung nach der Stufe b) und vor der Stufe c) im Bereich von 0,005 bis 0,45, gemessen mit der Xylolmethode, beträgt.

12. Sicherheits- und/oder Wertdokument enthaltend eine Leitstrulctur nach Anspruch 11.

## Claims

1. A method for preparing a layer that is conductive for electric current on a substrate comprising the following steps:
a) onto the substrate a coating of a first preparation is applied, which contains an organic binder, an aqueous or organic solvent and particles,
b) the substrate with the coating is subjected to a drying step for 0.1 to 100 min at 60 to 130 °C, wherein the solvent is removed, and wherein the coating forms a pore system comprising interconnected open pores between the particles and in the binder matrix, and
c) the substrate with the dried coating is treated with a second preparation for autocatalytic electroless metal coating.

2. The method of claim 1, wherein the substrate is an organic polymer, preferably selected from the group consisting of "PC (polycarbonate, in particular bisphenol A polycarbonate), PET (polyethylene terephthalate), PET-G, PET-F, PMMA (polymethyl methacrylate), ABS (acrylonitrile-butadiene-styrene), PE (polyethylene), PP (polypropylene), PI (polyimide or trans-polyisoprene), PVC (polyvinyl chloride), and copolymers of such polymers".

3. The method according to one of claims 1 or 2, wherein the substrate is a film or a composite film of a security and/or value document, in particular an identity card, passport, ID card, access control card, visa, ticket, driver's license, motor vehicle document, personalized security paper, credit card, or personalized chip card.

4. The method according to one of claims 1 to 3, wherein the conductive layer is an antenna structure, in particular of an RFID circuit.

5. The method according to one of claims 1 to 4, wherein the coating is applied in step a) by a printing process technology, in particular by screen printing.

6. The method according to one of claims 1 to 5, wherein the first preparation contains a proportion of solvent, preferably of an organic solvent of 2 to 30 wt-%, in particular 4 to 10 wt-%, referred to the total weight of the preparation.

7. The method according to one of claims 1 to 6, wherein the first preparation contains a proportion of 30 to 99 wt-%, preferably 70 to 95 wt-% of particles, preferably electrically conductive particles, in particular metal particles, for example silver particles.

8. The method according to one of claims 1 to 7, wherein 90 % of the particles, referred to volume, have a particle size in the range from 0.1 to 30 microns.

9. The method according to one of claims 1 to 8, wherein the second preparation is an aqueous solution with a metal salt and a reducing agent, and optionally in addition with a complexing agent and/or one or more auxiliary substances.

10. The method according to one of claims 1 to 9, wherein the pH of the second preparation is set by means of auxiliary substances to 6.0 - 8.5, in particular 6.0 - 7.3, preferably 6.8 - 7.2, optionally by means of a buffer.

11. A conductive structure with a substrate insulating electric current and a conductive layer arranged on the substrate and connected therewith and being conductive for electric current, wherein said conductive layer comprises a metallic network penetrating the volume of the conductive layer and being arranged in interstices between electrically conductive or non-conductive particles contained in the conductive layer, wherein the particles are connected to each other and to the substrate by an organic binder, obtainable according to any one of claims 1 to 10, wherein the open porosity of the coating after step b) and before step c) is in the range from 0.005 to 0.45, as measured by the xylene method.

12. A security and/or value document containing a conductive structure according to claim 11.

## Revendications

1. Procédé de fabrication d'une couche conduisant le courant électrique sur un substrat comportant les étapes suivantes:
a) le substrat reçoit un revêtement composé d'une première préparation contenant un liant organique, un solvant aqueux ou organique et des particules,
b) le substrat pourvu du revêtement est soumis à une étape de séchage pendant 0,1 à 100 min à 60 à 130 °C, de manière à éliminer le solvant, et dans laquelle le revêtement forme un système de pores comprenant des pores ouvertes interconnectées entre les particules et dans la matrice de liant, et
c) le substrat pourvu du revêtement séché est traité au moyen d'une deuxième préparation pour le revêtement métallique autocatalytique sans courant.

2. Procédé selon la revendication 1, dans lequel le substrat est un polymère organique, de préférence choisi à partir du groupe consistant en "PC (polycarbonate, en particulier polycarbonate de bisphénol A), PET (polytéréphthalate d'éthylène), PET-G, PET-F, PMMA (polyméthacrylate de méthyle), ABS (acrylonitrile-butadiène-styrène), PE (polyéthylène), PP (polypropylène), PI (polyimide ou trans-polyisoprène), PVC (polychlorure de vinyle), et copolymères de tels polymères".

3. Procédé selon une des revendications 1 ou 2, dans lequel le substrat est un film ou un film multicouche d'un document de sécurité et/ou valeur, en particulier une carte d'identité, passeport, carte ID, carte de contrôle d'accès, visa, ticket, permis de conduire, certificat d'immatriculation, titre financier personnalisé, carte de crédit, ou carte à puce personnalisée.

4. Procédé selon une des revendications 1 à 3, dans lequel la couche conductrice est une structure d'antenne, en particulier d'un circuit RFID.

5. Procédé selon une des revendications 1 à 4, dans lequel le revêtement est appliqué dans l'étape a) par une technique d'impression, en particulier par la sérigraphie.

6. Procédé selon une des revendications 1 à 5, dans lequel la première préparation contient une teneur en solvant, de préférence en solvant organique de 2 à 30 % en poids, en particulier 4 à 10 % en poids, par rapport au poids total de la préparation.

7. Procédé selon une des revendications 1 à 6, dans lequel la première préparation contient une teneur de 30 à 99 % en poids, de préférence 70 à 95 % en poids en particules, de préférence particules électriquement conductrices, en particulier particules métalliques, par exemple particules d'argent.

8. Procédé selon une des revendications 1 à 7, dans lequel 90 % des particules, par rapport au volume, ont une taille de particule comprise dans la gamme entre 0,1 et 30 µm.

9. Procédé selon une des revendications 1 à 8, dans lequel la deuxième préparation est une solution aqueuse avec un sel métallique et un agent de réduction, et optionnellement en addition avec un agent complexant et/ou une ou plusieurs substances auxiliaires.

10. Procédé selon une des revendications 1 à 9, dans lequel le pH de la deuxième préparation est ajusté au moyen de substances auxiliaires à 6,0 - 8,5, en particulier 6,0 - 7,3, de préférence 6,8 - 7,2, optionnellement au moyen d'un tampon.

11. Structure conductrice comprenant un substrat isolant le courant électrique et une couche disposée sur le substrat et liée à celui-ci et étant conductrice pour le courant électrique, cette couche conductrice comprenant un réseau métallique, qui traverse le volume de la couche conductrice et est disposé dans des interstices entre des particules électriquement conductrices ou non conductrices comprises dans la couche conductrice, dans lequel les particules sont liées les unes aux autres et au substrat par un liant organique, en particulier pouvant être obtenue selon une des revendications 1 à 10, dans lequel la porosité ouverte du revêtement après l'étape b) et avant l'étape c) est comprise dans la gamme entre 0,005 et 0,45, comme mesurée par la méthode de xylène.

12. Document de sécurité et/ou valeur contenant une structure conductrice selon la revendication 11.
